(19) Europäisches Patentamt
European Patent Office
Office européen des brevets

(11) **EP 3 269 038 B1**

(12) **EUROPÄISCHE PATENTSCHRIFT**

(45) Veröffentlichungstag und Bekanntmachung des Hinweises auf die Patenterteilung:
**29.04.2020  Patentblatt 2020/18**

(21) Anmeldenummer: **15716991.3**

(22) Anmeldetag: **09.03.2015**

(51) Int Cl.:
**H03K 17/95** $^{(2006.01)}$

(86) Internationale Anmeldenummer:
**PCT/EP2015/054839**

(87) Internationale Veröffentlichungsnummer:
**WO 2016/141965 (15.09.2016 Gazette 2016/37)**

(54) **OSZILLATOR UND INDUKTIVER NÄHERUNGSSCHALTER**

OSCILLATOR AND INDUCTIVE PROXIMITY SWITCH

OSCILLATEUR ET COMMUTATEUR DE PROXIMITÉ INDUCTIF

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**17.01.2018  Patentblatt 2018/03**

(73) Patentinhaber: **Pepperl+Fuchs AG
68307 Mannheim (DE)**

(72) Erfinder: **KÜHN, Thomas
68219 Mannheim (DE)**

(74) Vertreter: **Schiffer, Axel Martin et al
Rundfunkplatz 2
80335 München (DE)**

(56) Entgegenhaltungen:
EP-A2- 0 461 550          DE-A1-102009 028 619
DE-A1-102010 002 201   DE-A1-102010 042 512
DE-B4-102007 014 343   US-A1- 2010 225 332

EP 3 269 038 B1

**Beschreibung**

Die vorliegende Erfindung bezieht sich in einem ersten Gesichtspunkt auf einen Oszillator, insbesondere für einen induktiven Näherungsschalter, nach dem Oberbegriff des Anspruchs 1. Außerdem betrifft die Erfindung einen induktiven Näherungsschalter mit dem erfindungsgemäßen Oszillator.

Ein gattungsgemäßer Oszillator weist einen Schwingkreis mit mindestens einer Induktivität und einer Kapazität und einen rückgekoppelten Verstärker auf, wobei in einem Rückkopplungskreis des Verstärkers mindestens ein Abgleichwiderstand vorhanden ist.

Oszillatoren dieser Art werden für induktive Näherungsschalter und insbesondere für solche induktive Näherungsschalter verwendet, bei denen ein Nachweissignal für ein nachzuweisendes Target erzeugt wird, indem eine Bedämpfung des Oszillators durch das nachzuweisende, insbesondere metallische, Target ausgewertet wird.

Um eine definierte Funktionsweise solcher Oszillatoren zu gewährleisten, muss die Resonanzimpedanz, die gegeben ist durch den Quotienten aus der Induktivität und dem Produkt des effektiv wirksamen Widerstands und der Schwingkreiskapazität, hinreichend gut definiert sein. Beispielsweise kann bei Näherungsschaltern, welche eine Bedämpfung des Oszillators auswerten, um daraus ein Nachweissignal für das nachzuweisende Target zu erzeugen, ein Schaltabstand durch gezieltes Einstellen der Resonanzimpedanz in bestimmten Grenzen eingestellt werden. Der Schaltabstand ist dabei derjenige Abstand, bei welchem der Oszillator gerade noch schwingt. Nähert sich das nachzuweisende Target noch weiter an den induktiven Näherungsschalter an, nimmt die Dämpfung aufgrund der in dem nachzuweisenden Target erzeugten Wirbelströme weiter zu und die Dämpfung ist so stark, dass der Oszillator nicht mehr schwingungsfähig ist und, mit anderen Worten, die Schleifenverstärkung den Wert 1 nicht mehr erreichen kann.

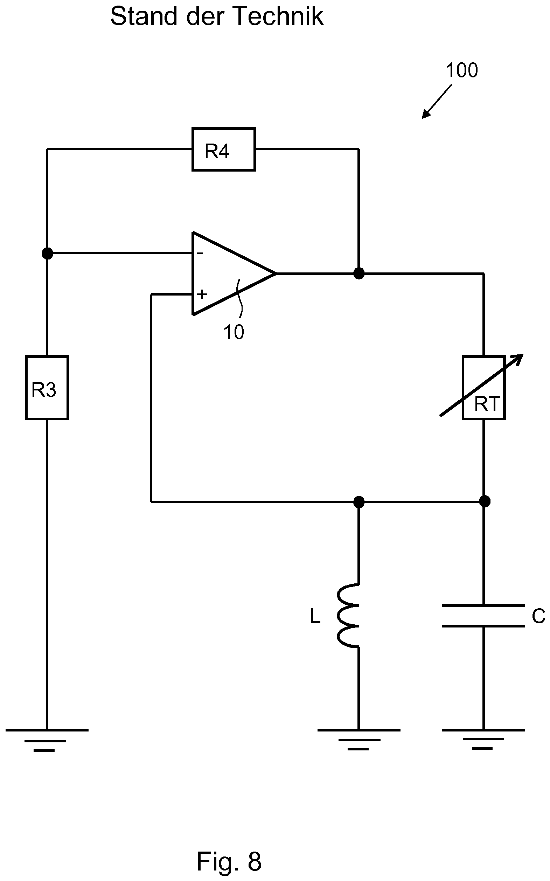

Diese Situation wird mit Bezug auf Fig. 8 näher erläutert. Gezeigt ist dort ein Oszillator 100 für einen induktiven Näherungsschalter, bei dem beispielsweise zum Erzeugen eines Nachweissignals für ein nachzuweisendes Target die von diesem Target verursachte Bedämpfung des Oszillators ausgewertet wird. Der Oszillator weist einen Schwingkreis mit einer Induktivität L und einer Kapazität C auf, die im gezeigten Beispiel parallel geschaltet und im Mitkopplungszweig eines Verstärkers 10 angeordnet sind. Der Ausgang des Verstärkers 10 ist über einen einstellbaren Widerstand RT mit der Induktivität L und der Kapazität C verbunden. Zum Einstellen der Verstärkung des Verstärkers 10 ist außerdem der Ausgang des Verstärkers 10 über einen Widerstand R4 auf den invertierenden Eingang rückgekoppelt. Außerdem ist der invertierende Eingang des Verstärkers 10 über einen Widerstand R3 mit Masse verbunden. Die Schwingkreisimpedanz kann mit Hilfe des einstellbaren Widerstands RT eingestellt werden. In der Praxis werden beispielsweise Trimmwiderstände eingesetzt, die werksseitig vor Auslieferung eines induktiven Näherungsschalters durch Bestrahlung mit einem Laser initial auf einen bestimmten Widerstandswert gebracht werden, durch welchen dann der Schaltabstand festgelegt ist. Diese Methode erlaubt keine nachträgliche Veränderung des Trimmwiderstands RT und damit kein nachträgliches Verändern des Schaltabstands.

Im Stand der Technik, beispielsweise aus DE 10 2007 014 343 B4, sind Lösungen bekannt, bei dem ein Widerstand durch einen parallel geschalteten Transistor, der zum Einstellen eines effektiven Widerstands nur teilweise geöffnet wird, bekannt. Bei solchen Schaltungen ergeben sich zusätzliche Anforderungen und Randbedingungen dadurch, dass die Basisspannung der Transistoren bezogen auf die absoluten Werte der Emitter- und Kollektorspannung einen bestimmten Wert aufweisen muss.

Näherungsschalter, bei denen Widerstände mit Techniken der Pulsweitenmodulation variiert werden, sind bekannt aus US 2010/0225332 A1, DE 10 2009 028 619 A1, DE 10 2010 042 512 A1, DE 10 2010 002 201 A1 und EP 0 461 550 A2.

Als eine **Aufgabe** der Erfindung kann erachtet werden, einen verbesserten Oszillator bereitzustellen, bei welchem eine Resonanzimpedanz besonders zuverlässig festgelegt werden kann und bei dem auch eine, insbesondere nachträgliche, Ände rung der Resonanzimpedanz prinzipiell möglich ist. Außerdem soll ein verbesserter Näherungsschalter geschaffen werden.

Diese Aufgabe wird durch den Näherungsschalter mit den Merkmalen des Anspruchs 1 gelöst.

Der Oszillator der oben angegebenen Art ist erfindungsgemäß dadurch weitergebildet, dass zum abwechselnden Zuschalten und Abschalten des Abgleichwiderstands eine elektronische Schalteinrichtung vorhanden ist, dass durch den Abgleichwiderstand und die elektronische Schalteinrichtung ein Abgleichkreis gebildet ist, dass zum Ansteuern der elektronischen Schalteinrichtung eine Ansteuereinrichtung vorhanden ist, dass die elektronische Schalteinrichtung zusammen mit der Ansteuereinrichtung zum abwechselnden Zuschalten und Abschalten des Abgleichwiderstands in einer Schaltfolge eingerichtet ist und dass durch die Schaltabfolge ein zeitlicher Mittelwert des elektrischen Widerstand des Abgleichkreises festlegbar oder festgelegt ist, der in einem Oszillatorbetrieb wirksam ist.

Als ein Grundgedanke der Erfindung kann angesehen werden, einen in einem Rückkopplungskreis des Verstärkers geschalteten Abgleichwiderstand nicht dauerhaft, sei es durch physikalische Einwirkung, wie durch Laserbestrahlung, oder durch einfaches Verstellen, wie bei einem Potentiometer, zu verändern, sondern diesen Abgleichwiderstand vielmehr in rascher zeitlicher Abfolge schnell zuzuschalten und abzuschalten, damit im Oszillatorbetrieb ein zeitlicher Mittelwert des elektrischen Widerstands des Abgleichkreises wirksam ist.

Als Oszillatorbetrieb wird im Rahmen dieser Beschreibung die Situation verstanden, in welcher eine Spannungsversorgung des Oszillators eingeschaltet ist. Der Oszillator kann dabei schwingfähig sein, also schwingen. Als Oszillatorbetrieb wird aber auch eine Situation bezeichnet, in der der Oszillator, beispielsweise wegen zu hoher Dämpfung, verursacht insbesondere durch einen erfindungsgemäßen Abgleichkreis und/oder ein dämpfendes Target, nicht schwingfähig ist.

Ein wesentlicher Vorteil eines solchen Oszillators besteht darin, dass die Oszillatorcharakteristik, also die gegen die Schwingungsamplitude aufgetragene Verstärkung, praktisch nicht verändert wird. Ein weiterer Vorteil ist, dass Temperatureinflüsse deutlich reduziert werden, das heißt, dass der zeitliche Mittelwert des Widerstands nur äußerst schwach von der Temperatur abhängt. Weiterhin wird durch den mit einer elektronischen Schalteinrichtung abwechselnd zu- und abschaltbaren Abgleichwiderstand ein streng monotoner und zugleich stetiger Abgleich ermöglicht. Das bedeutet, dass sich ein zeitlicher Mittelwert des elektrischen Widerstands des Abgleichkreises und damit die Resonanzimpedanz des Oszillators streng monoton und stetig ändern lassen.

Im Rahmen der vorliegenden Beschreibung bedeutet ein Zuschalten des Abgleichwiderstands, dass der Abgleichwiderstand in der elektronischen Schaltung mit Strom durchflossen wird, wohingegen im abgeschalteten Zustand des Abgleichwiderstands der Stromfluss durch den Abgleichwiderstand vernachlässigbar klein ist.

Der erfindungsgemäße Oszillator kann in praktisch jedem LC-Oszillator verwendet werden und ist außerdem kostengünstig realisierbar.

Im Vergleich zu im Stand der Technik bekannten Lösungen, bei denen ein Abgleich eines Oszillators mit einem schaltbaren Widerstandsnetzwerk vorgenommen wird, wird bei der Erfindung ein elektronischer Abgleich des Oszillators mit deutlich weniger Komponenten ermöglicht.

Für den erfindungsgemäßen Oszillator kommt es auf die Schaltabfolge im Einzelnen nur insoweit an, als durch diese Schaltabfolge ein zeitlicher Mittelwert des elektrischen Widerstands des Abgleichkreises festgelegt wird, dieser zeitliche Mittelwert des elektrischen Widerstands des Abgleichkreises mit anderen Worten, definiert ist, so dass in einem Oszillatorbetrieb die Resonanzimpedanz insgesamt zeitlich nicht variiert.

Die Schaltabfolge, also die zeitliche Abfolge von Zuschalten und Abschalten des Abgleichwiderstands durch die elektronische Schalteinrichtung, kann im Prinzip durch Analogschaltungen festgelegt sein. Besonders bevorzugt sind aber zum Einstellen der Schaltabfolge digitalelektronische Mittel, beispielsweise ein Mikrocontroller, vorhanden.

Prinzipiell kann die Schaltabfolge durch elektronische Mittel fest eingestellt sein. Bei solchen Varianten wird im Vergleich zu lasertrimmbaren Widerständen der Vorteil erreicht, dass die elektronischen Teilschaltungen, welche zum Einstellen der Schaltabfolge dienen, prinzipiell austauschbar sind. Die besonderen Vorteile der Erfindung werden aber bei Ausführungsbeispielen erzielt, bei denen der zeitliche Mittelwert des elektrischen Widerstands des Abgleichkreises durch Einstellen, mit anderen Worten durch Verändern, der Schaltabfolge veränderbar ist und dass der zeitliche Mittelwert des elektrischen Widerstands ansonsten aber, wenn die Schaltabfolge beibehalten wird, zeitlich konstant ist. Bei diesen Varianten kann, beispielsweise bei induktiven Näherungsschaltern, die einen erfindungsgemäßen Oszillator aufweisen, auch lange Zeit nach einer initialen Einstellung die Schaltabfolge und damit der zeitliche Mittelwert des elektrischen Widerstands des Abgleichkreises und letzten Endes die Resonanzimpedanz des Oszillators komfortabel verändert werden.

Generell ist der zeitliche Mittelwert des elektrischen Widerstands des Abgleichkreises gegeben durch den Wert des Abgleichwiderstands an sich und durch ein Verhältnis der Zeitdauern, in welchen der Abgleichwiderstand zugeschaltet ist, zu einer Summe der Zeitdauern, in denen der Abgleichwiderstand zugeschaltet ist und der Zeitdauern, in denen der Abgleichwiderstand abgeschaltet ist, insbesondere durch den Wert des Abgleichwiderstands und das Tastverhältnis einer Pulsweitenmodulation.

Der zeitliche Mittelwert des Widerstands des Abgleichkreises ist dabei über Mittelungsdauern zu nehmen, die groß sind im Vergleich zur Periodendauer des Oszillators, groß auch im Vergleich zu typischen Zeitabständen zwischen Schaltvorgängen der Schaltabfolge und insbesondere groß im Vergleich zu einer Periodendauer einer Pulsweitenmodulation.

Wenn im Rahmen der vorliegenden Patentanmeldung davon die Rede ist, dass der zeitliche Mittelwert des Widerstands des Abgleichkreises festgelegt oder zeitlich konstant ist, ist damit gemeint, dass der Widerstand dann nur noch abhängt möglichen Schwankungen, Driften oder Ungenauigkeiten der verwendeten Schaltungskomponenten, insbesondere also der verwendeten Widerstände, der zum Einsatz kommenden Schalteinrichtung und der verwendeten Ansteuereinrichtung. Weil bei der vorliegenden Erfindung vergleichsweise nur wenige Komponenten notwendig sind, können Driften und Ungenauigkeiten, die aus einer Vielzahl von zum Einsatz kommenden Komponenten resultieren, reduziert werden.

Bei der Schaltabfolge kommt es im Prinzip nur darauf an, dass diese so geartet ist, dass ein zeitlicher Mittelwert des elektrischen Widerstands des Abgleichkreises festlegbar oder festgelegt, also wohldefiniert ist. Bei einer besonders bevorzugten Ausführungsvariante ist die Schaltabfolge durch Pulsweitenmodulation mit einer Pulsweitenmodulationsfrequenz gegeben. Insbesondere kann eine Pulsweitenmodulation mit genau einer Frequenz zum Einsatz kommen. Darunter versteht man eine Schaltabfolge, bei welcher die Schalteinrichtung periodisch, nämlich mit einer zu der Pulsweitenmodulationsfrequenz gehörenden Periode betätigt wird und zwar so, dass die Schalteinrichtung den Abgleichwiderstand für jeweils gleiche Anschaltzeiten zuschaltet und, ebenfalls für jeweils gleiche Abschaltzeiten, abschaltet. Die Anschaltzeiten und Abschaltzeiten können beispielsweise gleich groß sein. Das Tastverhältnis ist in diesem Fall 0,5.

Das Tastverhältnis kann aber im Prinzip jeden Wert zwischen 0 und 1 annehmen. Von einer Situation, bei welcher der Abgleichwiderstand immer zugeschaltet ist bis zu einer Situation, bei welcher der Abgleichwiderstand immer abgeschaltet ist, können sämtliche Zwischenzustände eingenommen werden. Die Summe der Anschaltzeiten innerhalb einer Periode und der Abschaltzeiten innerhalb einer Periode ergibt die Periodendauer. Auch hierin manifestiert sich der für die Erfindung bedeutsame Umstand, dass der Abgleichwiderstand entweder zugeschaltet ist oder abgeschaltet ist. Zwischenzustände wie im Stand der Technik, wo beispielsweise ein Abgleichwiderstand über eine parallelgeschaltete Transistorstrecke etwa halb zugeschaltet wird, sind bei dem erfindungsgemäßen Oszillator nicht möglich. Die bei solchen Schaltungen des Stands der Technik vorhandenen Nichtlinearitäten und Temperaturdriften können bei der Erfindung vermieden werden.

Das Zu- und Abschalten des Abgleichwiderstands führt im Spektrum des Oszillatorstroms zu Seitenbändern oberhalb und unterhalb der Resonanzfrequenz. Diese Seitenbänder sind gegenüber der Resonanzfrequenz jeweils um die Frequenz der Pulsweitenmodulation nach oben beziehungsweise nach unten verschoben. Damit der Strom im Bereich der Resonanz und damit der Spannungsabfall am Schwingkreis bei der Resonanzfrequenz möglichst wenig gestört wird, wird die Frequenz der Pulsweitenmodulation oder bevorzugt alle Frequenzen der Schaltabfolge größer als die halbe Bandbreite, bevorzugt größer als die volle Bandbreite und besonders bevorzugt größer als die zehnfache Bandbreite gewählt. Dadurch wird erreicht, dass das Spektrum des Stroms im Bereich der Schwingkreisresonanz nicht nennenswert gestört wird.

Die Bandbreite kann als Quotient der Resonanzfrequenz und der Güte des Schwingkreises dargestellt werden.

Prinzipiell kommt es für die Schaltabfolge nur darauf an, dass ein zeitlicher Mittelwert des elektrischen Widerstands des Abgleichkreises festgelegt ist, der in einem Oszillatorbetrieb wirksam ist. Diese Festlegung eines zeitlichen Mittelwerts kann prinzipiell auch bei Ausführungsvarianten des erfindungsgemäßen Oszillators erreicht werden, bei denen ein Frequenzspektrum der Schaltabfolge im Vergleich zu einem Frequenzspektrum einer Pulsweitenmodulation mit einer einzigen Pulsweitenmodulationsfrequenz verbreitert ist und/oder zusätzliche Frequenzen enthält. Prinzipiell kann dabei auch mit Frequenzen gearbeitet werden, die kleiner sind als eine Bandbreite der Schwingkreisresonanz, vorausgesetzt die verwendete Frequenzverteilung der Schaltabfolge ist so breit, dass sie sich nur in vernachlässigbarer Weise auf die Schwingkreisresonanz auswirkt. Beispielsweise kann dies realisiert werden, wenn die Pulsweitenmodulationsfrequenz innerhalb eines Variationsintervalls, insbesondere kontinuierlich, gesweept wird, wobei der zeitliche Mittelwert des elektrischen Widerstands des Abgleichkreises beim Sweepen der Pulsweitenmodulationsfrequenz gleichbleibt.

Prinzipiell kann die Schaltabfolge auch eine zufällige Abfolge von Zuschaltzeiten und Abschaltzeiten sein, wobei gewährleistet sein muss, dass der zeitliche Mittelwert des Widerstands des Abgleichkreises wohldefiniert oder, mit anderen Worten, zeitlich konstant ist.

Im Hinblick auf die konkrete Verschaltung des Abgleichkreises in dem erfindungsgemäßen Oszillator besteht prinzipiell große Freiheit. Der Abgleichkreis kann in einen Mitkopplungskreis oder in einen Gegenkopplungskreis des Verstärkers geschaltet sein. Prinzipiell können auch sowohl im Mitkopplungskreis als auch im Gegenkopplungskreis des Verstärkers ein Abgleichkreis oder mehrere Abgleichkreise der hier beschriebenen Art vorhanden sein.

Sodann kann die elektronische Schalteinrichtung parallel zu dem Abgleichwiderstand geschaltet sein und der Abgleichwiderstand kann durch Kurzschluss über die elektronische Schalteinrichtung abgeschaltet werden. Bei dieser Ausführung kann der zeitliche Mittelwert des Widerstands des Abgleichkreises zwischen einem endlichen Maximalwert, der durch den Wert des Abgleichwiderstands gegeben ist, und praktisch null bei Kurzschluss variieren.

Ebenso kann die Schalteinrichtung in Reihe zu dem Abgleichwiderstand geschaltet ist und der Abgleichwiderstand kann durch die elektronische Schalteinrichtung abgeschaltet werden. Bei dieser Ausführung kann der zeitliche Mittelwert des Widerstands des Abgleichkreises zwischen einem endlichen Minimalwert, der durch den Wert des Abgleichwiderstands gegeben ist, und praktisch Unendlich bei geöffneter Schalteinrichtung variieren.

Sodann kann der Abgleichkreis sowohl parallel als auch in Reihe zu einem Widerstand, insbesondere einem Rückkopplungswiderstand, geschaltet sein. Wenn der Abgleichkreis parallel zu einem Rückkopplungswiderstand geschaltet ist, wird der Widerstand dieser Parallelschaltung von Widerständen bei zugeschaltetem Abgleichwiderstand abgesenkt. Bei Schaltung des Abgleichwiderstands in Reihe zu einem Rückkopplungswiderstand wird dem Rückkopplungswiderstand eine einstellbare additive Komponente hinzugefügt.

Diese Schaltvarianten können je nach Zweckdienlichkeit variiert und angepasst werden, ebenso wie die konkrete Dimensionierung der Abgleichwiderstände und der Rückkopplungswiderstände.

Als elektronische Schalteinrichtung kann im Prinzip jede elektronische Schalteinrichtung verwendet werden, bei denen innerhalb eines Arbeitsspannungsbereichs ein im Wesentlichen potenzialfreies Schalten möglich ist, also ein Schalten, welches von der konkret zu schaltenden Spannung nicht abhängt. Solche Komponenten, insbesondere auf CMOS-Basis, sind bekannt und werden als Analogschalter bezeichnet.

Bei besonders vorteilhaften Ausführungsvarianten wird die elektronische Schalteinrichtung digital angesteuert. Dies ist möglich, weil zur Einstellung des Widerstands nur zwei Zustände, nämlich der abgeschaltete und der zugeschaltete Zustand, benötigt werden. Zum Einstellen der Schaltfolge im Einzelnen können deshalb digitale Komponenten verwendet werden. Besonders vorteilhaft wird als Ansteuereinrichtung ein Mikrocontroller verwendet. Bevorzugt und zweckmäßig kann dieser Mikrocontroller auch zur Datenauswertung und für sonstige Mess- und Steueraufgaben verwendet werden.

Die Veränderung der Schaltabfolge des Abgleichkreises, mit anderen Worten die Veränderung des zeitlichen Mittelwerts des elektrischen Widerstands des Abgleichkreises kann prinzipiell für beliebige Zwecke verwendet werden. Besonders bevorzugt wird diese Möglichkeit des elektronischen Abgleichs genutzt, um den Schaltabstand einzustellen. Grundsätzlich kann dieser elektronische Abgleich aber auch dazu verwendet werden, noch bestehende Temperaturdriften zu kompensieren. Hierzu kann zweckmäßig eine Temperaturmesseinrichtung vorhanden sein zum Messen einer Temperatur mindestens des Schwingkreises. Auf Grundlage einer von der Temperaturmesseinrichtung gemessenen Temperatur kann dann die Schaltabfolge und damit der zeitliche Mittelwert des Widerstands des Abgleichkreises zum Kompensieren von Temperaturdriften verändert werden. Dies kann auf Grundlage von in einer Tabelle niedergelegten Daten und/oder auf Grundlage von, etwa im Programmspeicher eines Mikrocontrollers hinterlegten, Berechnungsalgorithmen erfolgen.

Die Vorteile des erfindungsgemäßen Oszillators kommen in besonderer Weise zum Tragen bei einem induktiven Näherungsschalter, welcher einen solchen erfindungsgemäßen Oszillator aufweist.

Insbesondere kann es sich dabei um induktive Näherungsschalter handeln, bei denen zum Erzeugen eines Nachweissignals, welches die Annäherung eines Targets signalisiert, eine Bedämpfung des Oszillators durch das nachzuweisende Target eine Änderung der Induktivität des Schwingkreises durch das Target und/oder eine Änderung einer Kopplung der Induktivität des Schwingkreises an eine weitere Induktivität, insbesondere eine Empfangsspule, auswertet.

Der erfindungsgemäße Näherungsschalter weist bevorzugt eine Auswerteeinrichtung, beispielsweise einen Mikrocontroller, auf zum Auswerten eines Schwingungszustands, insbesondere einer Schwingungsamplitude, des Oszillators. In Abhängigkeit von dem festgestellten Schwingungszustand, insbesondere also von einer festgestellten Schwingungsamplitude, generiert die Auswerteeinrichtung ein Ausgabesignal, welches der Näherungsschalter ausgibt und welches weiteren Komponenten, beispielweise einer übergeordneten Steuerung zugeführt werden kann. Prinzipiell kann es sich um ein kontinuierliches Ausgabesignal handeln. Besonders bevorzugt ist das Ausgabesignal aber ein binäres oder digitales Schaltsignal, welches angibt, ob sich ein nachzuweisendes Target näher als ein Schaltabstand an dem Näherungsschalter befindet oder ob das Target weiter als der Schaltabstand von dem Näherungsschalter entfernt ist. Bei der Auswerteeinrichtung kann es sich insbesondere um dieselbe elektronische Einrichtung handeln, die auch zum Ansteuern des mindestens einen Abgleichkreises verwendet wird. Besonders bevorzugt kommt als Auswerteeinrichtung ein Mikrocontroller zum Einsatz.

Bei Näherungsschaltern, die eine Dämpfung des Oszillators durch ein Target auswerten, ist der Schaltabstand gegeben durch den Abstand, bei dem der Oszillator beginnt zu schwingen, wenn sich das Target von dem Näherungsschalter entfernt, oder den Abstand, bei dem, wenn sich das Target dem Näherungsschalter annähert, die Dämpfung so stark wird, dass der Oszillator nicht mehr schwingen kann.

Bei besonders bevorzugten Varianten eines erfindungsgemäßen Näherungsschalters ist die Ansteuereinrichtung zum Einstellen des Schaltabstands durch Verändern der Schaltabfolge eingerichtet. Die Erfindung erlaubt also in besonders vorteilhafter Weise ein Einstellen des Schaltabstands. Bei Näherungsschaltern, die eine Dämpfung des Oszillators durch ein Target auswerten, kann der Schaltabstand verändert werden durch Verändern der Verstärkung des Oszillators und/oder durch Verändern der Dämpfung des Oszillators. Beides ist, wie weiter oben erläutert, je nach Verschaltung des Abgleichkreises bei dem erfindungsgemäßen Oszillator möglich.

Bei weiteren bevorzugten Varianten von erfindungsgemäßen induktiven Näherungsschaltern wird mit Hilfe des Abgleichkreises des Oszillators eine Schalthysterese bereitgestellt. Beispielsweise kann die Ansteuereinrichtung zum Bereitstellen einer Schalthysterese dazu eingerichtet sein, den Schaltabstand nach Schalten des Näherungsschalters aufgrund einer Annäherung eines Targets zu dem Näherungsschalter, insbesondere geringfügig, zu vergrößern und den Schaltabstand nach Schalten des Näherungsschalters aufgrund einer Entfernung des Targets von dem Näherungsschalter, insbesondere geringfügig, zu verringern.

Konkret kann das erreicht werden, wenn die Ansteuereinrichtung zum Bereitstellen einer Schalthysterese dazu eingerichtet ist, nach Schalten des Näherungsschalters aufgrund einer Annäherung eines Targets zu dem Näherungsschalter den zeitlichen Mittelwert des elektrischen Widerstands des Abgleichkreises zu erhöhen und nach Schalten des Näherungsschalters aufgrund einer Entfernung des Targets von dem Näherungsschalter den zeitlichen Mittelwert des elektrischen Widerstands des Abgleichkreises zu reduzieren.

Alternativ kann die Ansteuereinrichtung zum Bereitstellen einer Schalthysterese auch dazu eingerichtet sein, nach Schalten des Näherungsschalters aufgrund einer Annäherung eines Targets zu dem Näherungsschalter den zeitlichen Mittelwert des elektrischen Widerstands des Abgleichkreises zu reduzieren und nach Schalten des Näherungsschalters aufgrund einer Entfernung des Targets von dem Näherungsschalter den zeitlichen Mittelwert des elektrischen Widerstands des Abgleichkreises zu erhöhen.

Weitere Vorteile und Merkmale der Erfindung werden im Folgenden mit Bezug auf die beigefügten Figuren erläutert. Hierin zeigt:

Fig. 1: ein erstes Ausführungsbeispiel eines erfindungsgemäßen Oszillators;

Fig. 2: ein Teilschaltbild zum Veranschaulichen eines in dem Abgleichkreis fließenden Stroms;

Fig. 3: ein Diagramm, in dem der Strom in dem Abgleichkreis gegen die Frequenz aufgetragen ist;

Fig. 4: ein zweites Ausführungsbeispiel eines erfindungsgemäßen Oszillators;

Fig. 5: eine Schaltungsvariante, die bei dem Ausführungsbeispiel aus Fig. 1 oder dem Ausführungsbeispiel aus Fig. 4 zum Einsatz kommen kann;

Fig. 6: ein drittes Ausführungsbeispiel eines erfindungsgemäßen Oszillators;

Fig. 7: eine schematische Darstellung eines erfindungsgemäßen induktiven Näherungsschalters; und

Fig. 8: einen Oszillator nach dem Stand der Technik;

In allen Figuren sind gleiche oder gleich wirkende Komponenten in der Regel mit denselben Bezugszeichen gekennzeichnet.

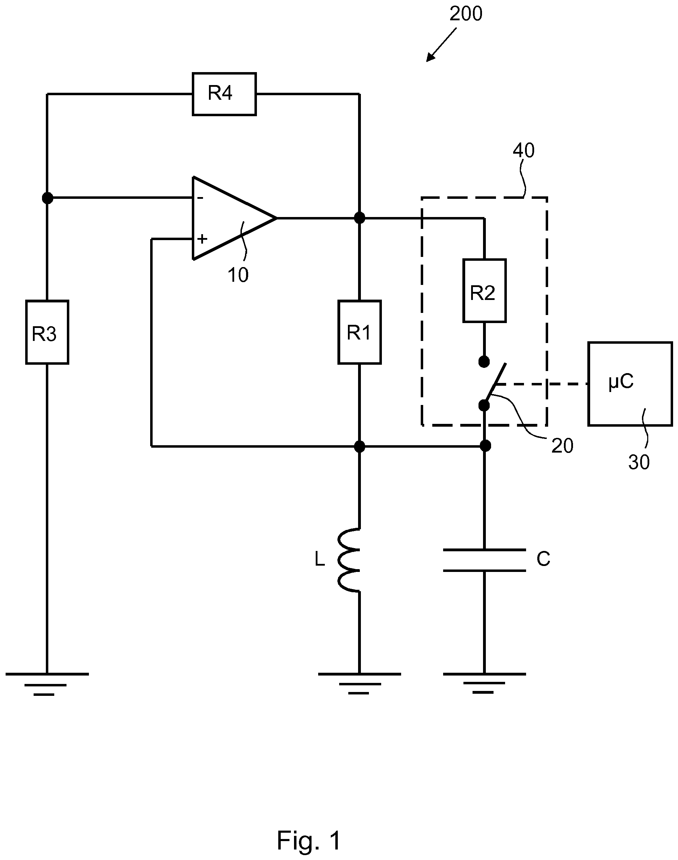

Ein erstes Ausführungsbeispiel eines erfindungsgemäßen Oszillators 200 ist in Fig. 1 dargestellt. Im Vergleich zu dem aus dem in Fig. 8 gezeigten Oszillator aus dem Stand der Technik ist bei der Schaltung in Fig. 1 parallel zum Widerstand R1 im Mitkopplungszweig des Verstärkers 10 ein Abgleichkreis 40 mit einem Abgleichwiderstand R2 und einer elektronischen Schalteinrichtung 20 geschaltet. Die elektronische Schalteinrichtung wird mit einer Ansteuereinrichtung 30, bei der es sich beispielsweise um einen Mikrocontroller handeln kann, angesteuert. Die Ansteuereinrichtung 30 steuert die elektronische Schalteinrichtung so an, dass der Abgleichwiderstand R2 in einer Schaltfolge abwechselnd zugeschaltet und abgeschaltet wird. Erfindungsgemäß wird dabei durch die Schaltabfolge ein zeitlicher Mittelwert des elektrischen Widerstands festgelegt, der in einem Betrieb des Oszillators 200 wirksam ist.

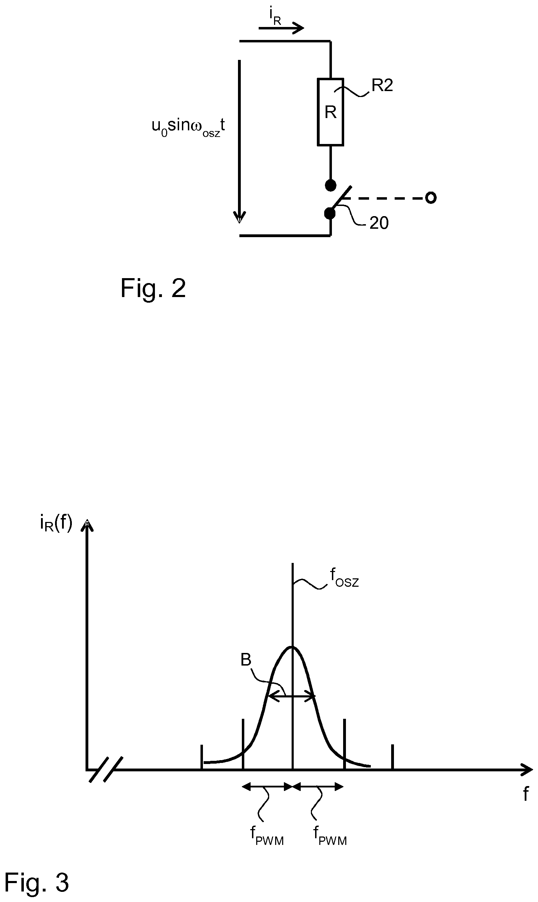

Beispielsweise kann die Schaltabfolge durch eine Pulsweitenmodulation mit einer einzigen Pulsweitenmodulationsfrequenz $f_{PWM}$ gegeben sein. Mit Bezug auf die Figuren 2 und 3 wird das näher erläutert. Fig. 2 veranschaulicht die elektrischen Größen Strom und Spannung am Abgleichwiderstand R2. Mit dem Ohmschen Gesetz und einer Fourierzerlegung der Pulsweitenmodulation kann der durch den Abgleichwiderstand R2 fließende Strom $i_R$ dargestellt werden:

$$i_R = \left(\frac{u_0}{R}\right) \sin(\omega_{OSZ} t) \times \{a_0 + a_1 \cos(\omega_{PWM} t) + a_2 \cos(2\omega_{PWM} t) + \cdots\}$$

Hierin ist $u_0 \sin(\omega_{OSZ} t)$ die am Abgleichwiderstand R2 anliegende Spannung, R ist der nominale Wert des Abgleichwiderstands R2, $\omega_{OSZ}$ ist die Kreisfrequenz der Resonanz des Oszillators, $\omega_{PWM} = 2\pi f_{PWM}$ ist die Kreisfrequenz der Pulsweitenmodulation und $a_0$, $a_1$, $a_2$ sind die Fourierkoeffizienten der Pulsweitenmodulation.

Das Verhältnis der Zeitdauer $T_{on}$, über welche die elektronische Schalteinrichtung 20 in einer Periodendauer $T_{PWM}$ geschlossen ist, der Abgleichwiderstand R2 also angeschaltet ist, und der Periodendauer $T_{PWM} = 2\pi/\omega_{PWM}$ der Pulsweitenmodulation ist das Tastverhältnis $p = a_0 = T_{on}/ T_{PWM}$ der Pulsweitenmodulation.

Die mit der Resonanzfrequenz $f_{OSZ}$ des Oszillators schwingende Stromkomponente ist:

$$\text{i}(f_{OSZ}) = u_0\, a_0/R = u_0\, p/R$$

Das heißt, dass der zeitliche Mittelwert des elektrischen Widerstands des Abgleichkreises 40, der auch als effektiver Widerstand $R_{eff}$ bezeichnet werden kann, gegeben ist durch:

$$R_{eff} = u_0/i(f_{OSZ}) = R/p$$

Die Situation im Frequenzraum ist in Fig. 3 schematisch dargestellt. Aufgetragen ist dort der Strom $i_R$ durch den Abgleichwiderstand R2 gegen die Frequenz. Der Stromverlauf entspricht einer typischen Resonanzkurve mit einer Breite B. Bei der Resonanzfrequenz $f_{OSZ} = \omega_{OSZ}/2\pi$ ist der Strom $i_R$ maximal.

Durch Pulsweitenmodulation mit der Pulsweitenmodulationsfrequenz $f_{PWM} = \omega_{PWM}/2\pi$ entstehen Seitenbänder im Stromspektrum, die um den Wert der Pulsweitenmodulationsfrequenz $f_{PWM}$ von der Resonanzfrequenz $f_{OSZ}$ beabstandet sind. Im Diagramm in Fig. 3 sind diese Seitenbänder durch $\delta$-artige Peaks bei den Frequenzen f = $f_{OSZ}$ +/- $f_{PWM}$ schematisch dargestellt. Bei den Frequenzen f = $f_{OSZ}$ +/- $2f_{PWM}$ finden sich weitere, jedoch schwächere Seitenbänder, die zu höheren Harmonischen gehören. Die Seitenbänder im Stromspektrum erzeugen einen Spannungsabfall am Schwingkreis, der als leichte Modulation sichtbar wird. Diese Modulationen können durch geeignete Wahl der Pulsweitenmodulationsfrequenz $f_{PWM}$ weitestgehend unterdrückt werden. Die Pulsweitenmodulationsfrequenz sollte so groß gewählt werden, dass die Seitenbänder nicht in die Bandbreite der Resonanzkurve fallen. Hieraus ergibt sich die Designvorschrift, dass die Pulsweitenmodulationsfrequenz nach Möglichkeit deutlich größer gewählt werden sollte, als die halbe Bandbreite B, die gegeben ist durch die Resonanzfrequenz des Oszillators dividiert durch die Schwingkreisgüte Q:

$$f_{PWM} \gg \frac{B}{2} = f_{OSZ}/Q$$

Bei der in Fig. 2 gezeigten Variante ist die elektronische Schalteinrichtung 20 in Reihe zum Abgleichwiderstand R2 geschaltet. Der Abgleichwiderstand R2 wird demgemäß durch Schließen der elektronischen Schalteinrichtung 20 zugeschaltet und durch Öffnen der Schalteinrichtung 20 abgeschaltet.

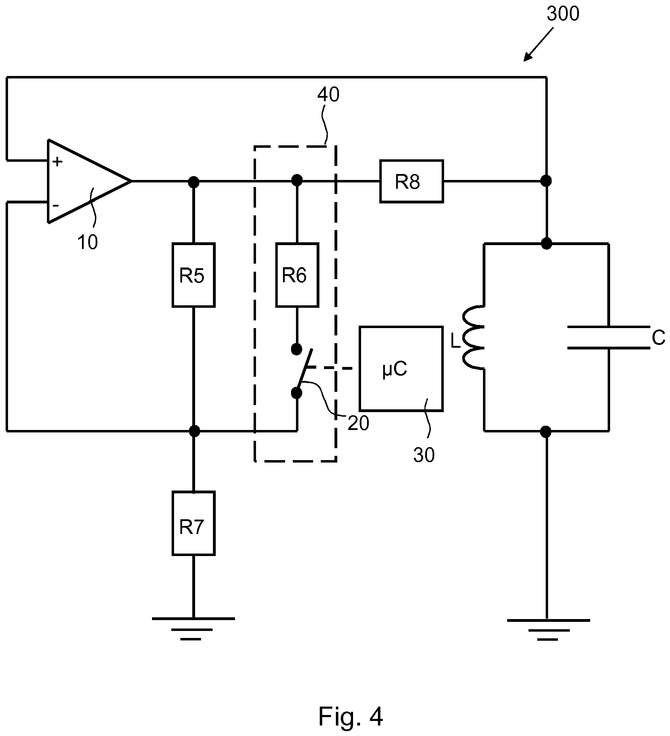

Ein Abgleichkreis 40 kann außerdem auch, so wie bei dem in Fig. 4 gezeigten Oszillator 300, in den Gegenkopplungskreis geschaltet werden. Durch die Widerstände R5, R7 und den Abgleichkreis 40 mit dem Widerstand R6 wird bei dem Beispiel aus Fig. 4 die Verstärkung des Verstärkers 10 eingestellt. Durch den Widerstand R8 wird eine Vorbedämpfung des Schwingkreises L, C bereitgestellt. Hier kommen dieselben Vorteile zum Tragen, insbesondere wird die Oszillatorcharakteristik durch den Abgleichkreis 40 nicht beeinflusst, es bestehen nur vernachlässigbare Temperatureinflüsse und durch den erfindungsgemäß vorgesehen Abgleichkreis kann ein prinzipiell streng monotoner und stetiger Abgleich vorgenommen werden.

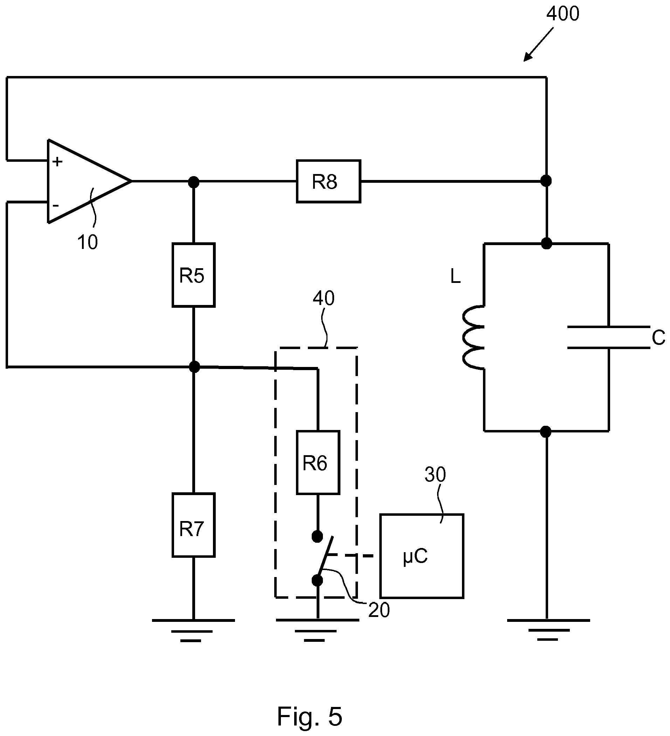

Fig. 5 zeigt ein drittes Ausführungsbeispiel eines erfindungsgemäßen Oszillators 400. Dabei handelt es sich um eine Variante der in Fig. 4 gezeigten Schaltung. Wie aus Fig. 5 ersichtlich, ist dort der Abgleichkreis 40 mit dem Abgleichwiderstand R6 parallel zum Widerstand R7 gegen Masse geschaltet. Diese Schaltungsalternativen können, je nach Zweckdienlichkeit, insbesondere je nach gewünschter Einstellmöglichkeit gewählt werden. Prinzipiell ist es auch möglich, die Abgleicheinrichtung 40 parallel zu der Kapazität C und der Induktivität L zu schalten.

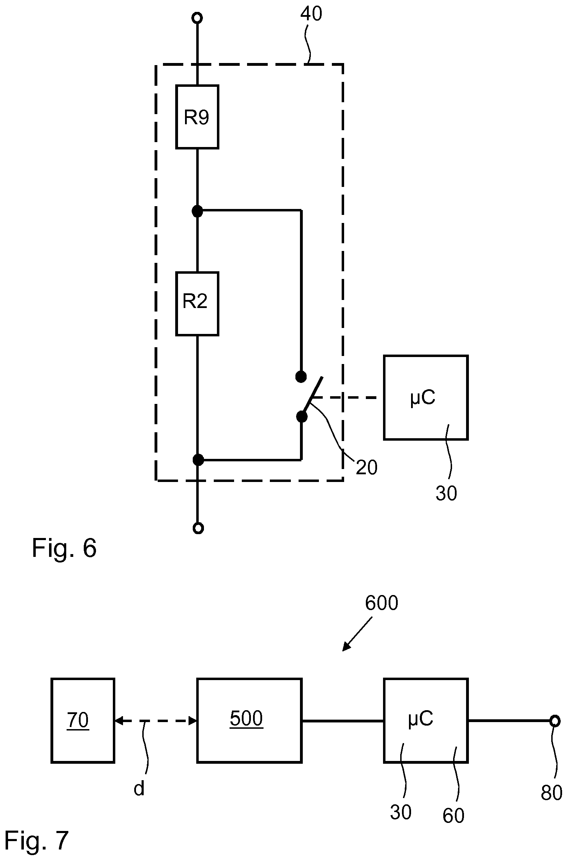

Prinzipiell sind auch Varianten möglich, wie in Fig. 6 gezeigt, bei denen die elektronische Schalteinrichtung 20 parallel zum Abgleichwiderstand R2 geschaltet ist. Der Abgleichwiderstand R2 wird dann durch Schließen der elektronischen Schalteinrichtung 20 abgeschaltet, nämlich kurzgeschlossen (der Widerstand des Abgleichkreises 40 ist dann durch den Widerstand R9 gegeben) und durch Öffnen der elektronischen Schalteinrichtung 20 zugeschaltet.

Fig. 7 zeigt in schematischer Darstellung einen erfindungsgemäßen induktiven Näherungsschalter 600. Dieser weist einen erfindungsgemäßen Oszillator 500 und eine Auswerteeinrichtung 60 auf. Im gezeigten Beispiel handelt es sich bei der Auswerteeinrichtung 60 um denselben Mikrocontroller, der auch als Ansteuereinrichtung 30 in dem hier nicht dargestellten Abgleichkreis des Oszillators 500 fungiert. Die Auswerteeinrichtung 60 wertet in grundsätzlich bekannter Weise einen Schwingungszustand, insbesondere eine Schwingungsamplitude, des Oszillators 500 aus. In Abhängigkeit dieser Auswertung gibt die Auswerteeinrichtung 60 an einem Ausgang 80 ein, insbesondere binäres, Schaltsignal aus. In der in Fig. 7 gezeigten Situation befindet sich ein Target 70 gerade in einem Schaltabstand d von dem Oszillator 500 als Teil des Näherungsschalters 600.

Mit der vorliegenden Erfindung wird ein neuartiger Oszillator vorgestellt, der sich insbesondere für den Einsatz bei induktiven Näherungsschaltern eignet und der besonders einfach abzugleichen ist und bei dem vor allem der Abgleich jederzeit verändert und neu justiert werden kann.

Bezugszeichenliste

| | |
|---|---|
| 10 | Verstärker |
| 20 | elektronische Schalteinrichtung |
| 30 | Ansteuereinrichtung, Mikrocontroller |
| 40 | Abgleichkreis |
| 60 | Auswerteeinrichtung |

| | |
|---|---|
| 70 | Target |
| 80 | Schaltausgang |
| 100 | Oszillator nach dem Stand der Technik |
| 200 | erfindungsgemäßer Oszillator |
| 300 | erfindungsgemäßer Oszillator |
| 400 | erfindungsgemäßer Oszillator |
| 500 | erfindungsgemäßer Oszillator |
| 600 | Näherungsschalter |
| B | Bandbreite der Schwingkreisresonanz |
| d | Schaltabstand |
| f | Frequenz |
| $f_{OSZ}$ | Resonanzfrequenz des Schwingkreises |
| $f_{PWM}$ | Frequenz einer Pulsweitenmodulation |
| $i_R$ | Strom durch Widerstand R |
| $i_R(f)$ | Strom als Funktion der Frequenz |
| C | Kapazität des Schwingkreises |
| L | Induktivität des Schwingkreises |
| R1 | Widerstand im Mitkopplungskreis |
| R2 | Abgleichwiderstand |
| R3 | Widerstand im Gegenkopplungskreis, Teil eines Spannungsteilers |
| R4 | Widerstand im Gegenkopplungskreis, Teil eines Spannungsteilers |
| R5 | Widerstand im Gegenkopplungskreis, Teil eines Spannungsteilers |
| R6 | Widerstand eines Abgleichkreises 40 |
| R7 | Widerstand im Gegenkopplungskreis, Teil eines Spannungsteilers |
| R8 | Widerstand im Mitkopplungskreis |
| R9 | Widerstand im Abgleichkreis |
| RT | Einstellbarer Widerstand |

## Patentansprüche

**1.** Induktiver Näherungsschalter, der zum Erzeugen eines Nachweissignals ausgebildet ist, welches die Annäherung eines Targets signalisiert, wobei der Näherungsschalter eine Bedämpfung eines Oszillators durch das nachzuweisende Target, auswertet,

mit dem Oszillator, der einen Schwingkreis mit mindestens einer Induktivität (L) und mindestens einer Kapazität (C) und einen rückgekoppelten Verstärker (10) aufweist,

wobei in mindestens einem Rückkopplungskreis des Verstärkers (10) mindestens ein Abgleichwiderstand (R2) vorhanden ist,

wobei zum abwechselnden Zuschalten und Abschalten des Abgleichwiderstands (R2) eine elektronische Schalteinrichtung (20) vorhanden ist,

wobei durch den Abgleichwiderstand (R2) und die elektronische Schalteinrichtung (20) ein Abgleichkreis (40) gebildet ist,

wobei zum Ansteuern der elektronischen Schalteinrichtung (20) eine Ansteuereinrichtung (30) vorhanden ist,

wobei die elektronische Schalteinrichtung (20) zusammen mit der Ansteuereinrichtung (30) zum abwechselnden Zuschalten und Abschalten des Abgleichwiderstands (R2) in einer Schaltabfolge eingerichtet ist und

wobei durch die Schaltabfolge ein zeitlicher Mittelwert des elektrischen Widerstands des Abgleichkreises (40) festgelegt ist,

**dadurch gekennzeichnet,**

**dass** der zeitliche Mittelwert über Mittelungsdauern zu nehmen ist, die groß sind im Vergleich zu einer Periodendauer des Oszillators und groß sind im Vergleich zu typischen Zeitabständen zwischen Schaltvorgängen der Schaltabfolge, und

**dass** der festgelegte zeitliche Mittelwert des elektrischen Widerstands des Abgleichkreises in einem Oszillatorbetrieb wirksam ist, sodass eine Resonanzimpedanz des Oszillators zeitlich nicht variiert.

**2.** Induktiver Näherungsschalter nach Anspruch 1,
**dadurch gekennzeichnet,**
**dass** digitalelektronische Mittel, beispielsweise ein Mikrocontroller, zum Einstellen der Schaltabfolge vorhanden sind.

**3.** Induktiver Näherungsschalter nach Anspruch 1 oder 2,
**dadurch gekennzeichnet,**
**dass** der zeitliche Mittelwert des elektrischen Widerstands des Abgleichkreises (40) bei Beibehalten der Schaltabfolge zeitlich konstant ist.

**4.** Induktiver Näherungsschalter nach einem der Ansprüche 1 bis 3,
**dadurch gekennzeichnet,**
**dass** der zeitliche Mittelwert des elektrischen Widerstands des Abgleichkreises (40) durch Einstellen der Schaltabfolge veränderbar ist.

**5.** Induktiver Näherungsschalter nach einem der Ansprüche 1 bis 4,
**dadurch gekennzeichnet,**
**dass** die Schaltabfolge durch eine Pulsweitenmodulation mit einer, insbesondere einer einzigen, Pulsweitenmodulationsfrequenz gegeben ist.

**6.** Induktiver Näherungsschalter nach einem der Ansprüche 1 bis 5,
**dadurch gekennzeichnet,**
**dass** der zeitliche Mittelwert des elektrischen Widerstands des Abgleichkreises (40) gegeben ist durch den Wert des Abgleichwiderstands (R2) und durch ein Verhältnis der Zeitdauern, in welchen der Abgleichwiderstand (R2) zugeschaltet ist, zu einer Summe der Zeitdauern, in denen der Abgleichwiderstand (R2) zugeschaltet ist, und der Zeitdauern, in denen der Abgleichwiderstand (R2) abgeschaltet ist, insbesondere durch den Wert des Abgleichwiderstands und das Tastverhältnis einer Pulsweitenmodulation.

**7.** Induktiver Näherungsschalter nach einem der Ansprüche 1 bis 5,
**dadurch gekennzeichnet,**
**dass** ein Frequenzspektrum der Schaltabfolge im Vergleich zu einem Frequenzspektrum einer Pulsweitenmodulation mit einer einzigen Pulsweitenmodulationsfrequenz verbreitert ist und/oder zusätzliche Frequenzen enthält.

**8.** Induktiver Näherungsschalter nach Anspruch 7,
**dadurch gekennzeichnet,**
**dass** eine Pulsweitenmodulationsfrequenz innerhalb eines Variationsintervalls, insbesondere kontinuierlich, gesweept wird, wobei der zeitliche Mittelwert des elektrischen Widerstands des Abgleichkreises (40) beim Sweepen der Pulsweitenmodulationsfrequenz gleichbleibt.

**9.** Induktiver Näherungsschalter nach Anspruch 7,
**dadurch gekennzeichnet,**
**dass** die Schaltabfolge eine Zufallsabfolge von Abschaltzeiten und Zuschaltzeiten ist, wobei der zeitliche Mittelwert des Widerstands des Abgleichkreises (40) zeitlich konstant ist.

**10.** Induktiver Näherungsschalter nach einem der Ansprüche 1 bis 9,
**dadurch gekennzeichnet,**
**dass** eine Frequenz oder alle Frequenzen der Schaltabfolge, insbesondere die Frequenz der Pulsweitenmodulation, größer ist oder größer sind als eine halbe Bandbreite der Schwingkreisresonanz, bevorzugt größer als eine ganze Bandbreite und besonders bevorzugt größer als das zehnfache der Bandbreite der Schwingkreisresonanz.

**11.** Induktiver Näherungsschalter nach einem der Ansprüche 1 bis 10,
**dadurch gekennzeichnet,**
**dass** der oder ein Abgleichkreis (40) in einen Mitkopplungskreis und/oder in einen Gegenkopplungskreis des Verstärkers (10) geschaltet ist.

**12.** Induktiver Näherungsschalter nach einem der Ansprüche 1 bis 11,
**dadurch gekennzeichnet,**
**dass** der Abgleichkreis (40) parallel oder in Reihe zu einem Rückkopplungswiderstand (R1) geschaltet ist.

**13.** Induktiver Näherungsschalter nach einem der Ansprüche 1 bis 12,
**dadurch gekennzeichnet,**

**dass** die elektronische Schalteinrichtung (20) parallel zu dem Abgleichwiderstand (R2) geschaltet ist und dass der Abgleichwiderstand (R2) durch Kurzschluss über die elektronische Schalteinrichtung (20) abschaltbar ist oder dass die Schalteinrichtung (20) in Reihe zu dem Abgleichwiderstand (R2) geschaltet ist und dass der Abgleichwiderstand (R2) durch Öffnen der elektronischen Schalteinrichtung (20) abschaltbar ist.

14. Induktiver Näherungsschalter nach einem der Ansprüche 1 bis 13,
**dadurch gekennzeichnet,**
**dass** die elektronische Schalteinrichtung (20) ein Analogschalter, insbesondere auf CMOS-Basis, ist.

15. Induktiver Näherungsschalter nach einem der Ansprüche 1 bis 14,
**dadurch gekennzeichnet,**
**dass** die Ansteuereinrichtung (30) ein Mikrocontroller ist.

16. Induktiver Näherungsschalter nach einem der Ansprüche 1 bis 15,
**dadurch gekennzeichnet,**
**dass** die Ansteuereinrichtung (30) die elektronische Schalteinrichtung (20) digital ansteuert.

17. Induktiver Näherungsschalter nach einem der Ansprüche 1 bis 16,
**dadurch gekennzeichnet,**
**dass** eine Temperaturmesseinrichtung zum Messen der Temperatur mindestens des Schwingkreises vorhanden ist und dass auf Grundlage einer von der Temperaturmesseinrichtung gemessenen Temperatur die Schaltabfolge zum Kompensieren von Temperaturdriften veränderbar ist.

18. Induktiver Näherungsschalter nach einem der Ansprüche 1 bis 17,
**dadurch gekennzeichnet,**
**dass** die Ansteuereinrichtung (30) zum Einstellen eines Schaltabstands durch Verändern der Schaltabfolge eingerichtet ist.

19. Induktiver Näherungsschalter nach einem der Ansprüche 1 bis 18,
**dadurch gekennzeichnet,**
**dass** die Ansteuereinrichtung (30) zum Bereitstellen einer Schalthysterese dazu eingerichtet ist,
den Schaltabstand nach Schalten des Näherungsschalters aufgrund einer Annäherung eines Targets zu dem Näherungsschalter, insbesondere geringfügig, zu vergrößern und
den Schaltabstand nach Schalten des Näherungsschalters aufgrund einer Entfernung des Targets von dem Näherungsschalter, insbesondere geringfügig, zu verringern.

20. Induktiver Näherungsschalter nach Anspruch 19,
**dadurch gekennzeichnet,**
**dass** die Ansteuereinrichtung (30) zum Bereitstellen einer Schalthysterese dazu eingerichtet ist, nach Schalten des Näherungsschalters aufgrund einer Annäherung eines Targets zu dem Näherungsschalter den zeitlichen Mittelwert des elektrischen Widerstands des Abgleichkreises zu erhöhen und nach Schalten des Näherungsschalters aufgrund einer Entfernung des Targets von dem Näherungsschalter den zeitlichen Mittelwert des elektrischen Widerstands des Abgleichkreises zu reduzieren oder
**dass** die Ansteuereinrichtung (30) zum Bereitstellen einer Schalthysterese dazu eingerichtet ist, nach Schalten des Näherungsschalters aufgrund einer Annäherung eines Targets zu dem Näherungsschalter den zeitlichen Mittelwert des elektrischen Widerstands des Abgleichkreises zu reduzieren und nach Schalten des Näherungsschalters aufgrund einer Entfernung des Targets von dem Näherungsschalter den zeitlichen Mittelwert des elektrischen Widerstands des Abgleichkreises zu erhöhen.

## Claims

1. Inductive proximity switch which is designed for generating a detection signal signaling the approach of a target, where the proximity switch evaluates a damping of an oscillator by the target to be detected,
having the oscillator which comprises a resonant circuit having at least one inductor (L) and at least one capacitor (C) and
a feedback amplifier (10),
wherein in at least one feedback circuit of the amplifier (10) there is at least one trimming resistor (R2),

wherein there is an electronic switching device (20) for alternately switching on and switching off the trimming resistor (R2),

wherein a trimming circuit (40) is formed by the trimming resistor (R2) and the electronic switching device (20),

wherein there is a control device (30) to control the electronic switching device (20),

wherein the electronic switching device (20), together with the control device (30), is designed to alternately switch on and switch off the trimming resistor (R2) in a switching sequence and

wherein a temporal mean value of the electrical resistance of the trimming circuit (40) is defined by the switching sequence,

**characterised in**

**that** the temporal mean value is to be taken over averaging durations that are large in comparison with the period duration of the oscillator and large in comparison with typical time intervals between switching processes of the switching sequence, and

**that** the defined temporal mean value of the electrical resistance of the trimming circuit is effective during oscillator operation such that a resonance impedance of the oscillator does not vary over time.

2.  Inductive proximity switch according to claim 1,
    **characterised in that**
    there are digital-electronic means, for example a microcontroller, for adjusting the switching sequence.

3.  Inductive proximity switch according to claim 1 or 2,
    **characterised in that**
    the temporal mean value of the electrical resistance of the trimming circuit (40) is time-constant when the switching sequence is maintained.

4.  Inductive proximity switch according to one of claims 1 to 3,
    **characterised in that**
    the temporal mean value of the electrical resistance of the trimming circuit (40) can be changed by adjusting the switching sequence.

5.  Inductive proximity switch according to one of claims 1 to 4,
    **characterised in that**
    the switching sequence is given by a pulse width modulation with a, in particular single, pulse width modulation frequency.

6.  Inductive proximity switch according to one of claims 1 to 5,
    **characterised in that**
    the temporal mean value of the electrical resistance of the trimming circuit (40) is given by the value of the trimming resistor (R2) and by a ratio of the periods in which the trimming resistor (R2) is switched on, to a sum of the periods in which the trimming resistor (R2) is switched on, and the periods in which the trimming resistor (R2) is switched off, in particular by the value of the trimming resistor and the duty cycle of a pulse width modulation.

7.  Inductive proximity switch according to one of claims 1 to 5,
    **characterised in that**
    a frequency spectrum of the switching sequence, in comparison with a frequency spectrum of a pulse width modulation, is expanded by a single pulse width modulation frequency and / or contains additional frequencies.

8.  Inductive proximity switch according to claim 7,
    **characterised in that**
    a pulse width modulation frequency is swept, in particular continuously, within a variation interval, wherein the temporal mean value of the electrical resistance of the trimming circuit (40) remains constant during sweeping of the pulse width modulation frequency.

9.  Inductive proximity switch according to claim 7,
    **characterised in that**
    the switching sequence is an arbitrary sequence of switching on and switching off times, wherein the temporal mean value of the resistance of the trimming circuit (40) is time-constant.

10. Inductive proximity switch according to one of claims 1 to 9,

**characterised in that**
a frequency or all frequencies of the switching sequence, in particular the frequency of the pulse width modulation, is / are greater than half a bandwidth of the resonant circuit resonance, preferably greater than a total bandwidth and particularly preferably greater than ten times the bandwidth of the resonant circuit resonance.

11. Inductive proximity switch according to one of claims 1 to 10,
**characterised in that**
the, or a, trimming circuit (40) is connected in a positive feedback circuit and / or in a negative feedback circuit of the amplifier (10).

12. Inductive proximity switch according to one of claims 1 to 11,
**characterised in that**
the trimming circuit (40) is connected in parallel or in series with a feedback resistor (R1).

13. Inductive proximity switch according to one of claims 1 to 12,
**characterised in that**
the electronic switching device (20) is connected in parallel with the trimming resistor (R2), and the trimming resistor (R2) can be switched off by short-circuit via the electronic switching device (20), or
the switching device (20) is connected in series with the trimming resistor (R2), and the trimming resistor (R2) can be switched off by opening the electronic switching device (20).

14. Inductive proximity switch according to one of claims 1 to 13,
**characterised in that**
the electronic switching device (20) is an analog switch, in particular CMOS-based.

15. Inductive proximity switch according to one of claims 1 to 14,
**characterised in that**
the control device (30) is a microcontroller.

16. Inductive proximity switch according to one of claims 1 to 15,
**characterised in that**
the control device (30) digitally controls the electronic switching device (20).

17. Inductive proximity switch according to one of claims 1 to 16,
**characterised in that**
there is a temperature measuring device for measuring the temperature of at least the resonant circuit and, based on a temperature measured by the temperature measuring device, the switching sequence can be changed to compensate for temperature drifts.

18. Inductive proximity switch according to one of claims 1 to 17,
**characterised in that**
the control device (30) is designed to adjust a switching distance by changing the switching sequence.

19. Inductive proximity switch according to one of claims 1 to 18,
**characterised in that**
the control device (30), for providing a switching hysteresis, is designed to increase, in particular negligibly, the switching distance after switching of the proximity switch due to a target approaching the proximity switch, and to decrease, in particular negligibly, the switching distance after switching of the proximity switch due to the target moving away from the proximity switch.

20. Inductive proximity switch according to claim 19,
**characterised in that**
the control device (30), for providing a switching hysteresis, is designed, after switching of the proximity switch due to a target approaching the proximity switch, to increase the temporal mean value of the electrical resistance of the trimming circuit and, after switching of the proximity switch due to the target moving away from the proximity switch, to reduce the temporal mean value of the electrical resistance of the trimming circuit or
the control device (30) for providing a switching hysteresis is designed, after switching of the proximity switch due to a target approaching the proximity switch, to reduce the temporal mean value of the electrical resistance of the trimming circuit and, after switching of the proximity switch due to the target moving away from the proximity switch, to increase the temporal mean value of the electrical resistance of the trimming circuit.

**Revendications**

1. Détecteur de proximité inductif, qui est conçu pour produire un signal de détection, lequel signale le rapprochement d'une cible, dans lequel le détecteur de proximité évalue un amortissement d'un oscillateur par la cible à détecter, avec l'oscillateur, qui présente un circuit résonant avec au moins une bobine d'inductance (L) et au moins un condensateur (C) et un amplificateur (10) à rétroaction,
dans lequel au moins une résistance d'équilibrage (R2) est présente dans au moins un circuit de rétroaction de l'amplificateur (10),
dans lequel un dispositif de commutation électronique (20) est présent pour l'activation et la désactivation alternées de la résistance d'équilibrage (R2), dans lequel un circuit d'équilibrage (40) est formé par la résistance d'équilibrage (R2) et le dispositif de commutation électronique (20),
dans lequel, pour commander le dispositif de commutation électronique (20), un dispositif de commande (30) est présent,
dans lequel le dispositif de commutation électronique (20) est conçu, conjointement avec le dispositif de commande (30), pour l'activation et la désactivation alternées de la résistance d'équilibrage (R2) en une série de commutations et
dans lequel une valeur moyenne temporelle de la résistance électrique du circuit d'équilibrage (40) est déterminée par la série de commutations, **caractérisé en ce**
**que** la valeur moyenne temporelle est à prendre pendant des durées de calcul de moyenne qui sont importantes en comparaison d'une période de l'oscillateur et importantes en comparaison d'intervalles de temps habituels entre des processus de commutation de la demande de commutation, et que la valeur moyenne temporelle déterminée de la résistance électrique du circuit d'équilibrage est active dans un mode de fonctionnement d'oscillateur, de sorte qu'une impédance de résonance de l'oscillateur ne varie pas dans le temps.

2. Détecteur de proximité inductif selon la revendication 1,
**caractérisé en ce**
**que** des moyens électroniques numériques, par exemple un microcontrôleur, sont présents pour le réglage de la série de commutations.

3. Détecteur de proximité inductif selon la revendication 1 ou 2,
**caractérisé en ce**
**que** la valeur moyenne temporelle de la résistance électrique du circuit d'équilibrage (40) est constante dans le temps lors du maintien de la série de commutations.

4. Détecteur de proximité inductif selon l'une quelconque des revendications 1 à 3,
**caractérisé en ce**
**que** la valeur moyenne temporelle de la résistance électrique du circuit d'équilibrage (40) peut être modifiée par réglage de la série de commutations.

5. Détecteur de proximité inductif selon l'une quelconque des revendications 1 à 4,
**caractérisé en ce**
**que** la série de commutations est fournie par une modulation d'impulsions en largeur avec une, en particulier une seule, fréquence de modulation d'impulsions en largeur.

6. Détecteur de proximité inductif selon l'une quelconque des revendications 1 à 5,
**caractérisé en ce**
**que** la valeur moyenne temporelle de la résistance électrique du circuit d'équilibrage (40) est fournie par la valeur de la résistance d'équilibrage (R2) et par un rapport des durées pendant lesquelles la résistance d'équilibrage (R2) est désactivée, sur une somme des durées pendant lesquelles la résistance d'équilibrage (R2) est désactivée, et des durées pendant lesquelles la résistance d'équilibrage (R2) est désactivée, en particulier par la valeur de la résistance d'équilibrage et le rapport cyclique d'une modulation d'impulsions en largeur.

7. Détecteur de proximité inductif selon l'une quelconque des revendications 1 à 5,
**caractérisé en ce**
**qu'**un spectre de fréquence de la série de commutations est élargi en comparaison d'un spectre de fréquence d'une modulation d'impulsions en largeur avec une seule fréquence de modulation d'impulsions en largeur et/ou contient des fréquences supplémentaires.

8. Détecteur de proximité inductif selon la revendication 7,
**caractérisé en ce**
**qu'**une fréquence de modulation d'impulsions en largeur est balayée, en particulier en continu, à l'intérieur d'un intervalle de variation, dans lequel la valeur moyenne temporelle de la résistance électrique du circuit d'équilibrage (40) reste identique lors du balayage de la fréquence de modulation d'impulsions en largeur.

9. Détecteur de proximité inductif selon la revendication 7,
**caractérisé en ce**
**que** la série de commutations est une série aléatoire de durées de désactivation et de durées d'activation, dans lequel la valeur moyenne temporelle de la résistance du circuit d'équilibrage (40) est constante dans le temps.

10. Détecteur de proximité inductif selon l'une quelconque des revendications 1 à 9,
**caractérisé en ce**
**qu'**une fréquence ou toutes les fréquences de la série de commutations, en particulier la fréquence de la modulation d'impulsions en largeur, est supérieure ou sont supérieures à une demi-bande passante de la résonance du circuit résonant, de préférence supérieures à une bande passante complète et de manière particulièrement préférée supérieures au décuple de la bande passante de la résonance du circuit résonant.

11. Détecteur de proximité inductif selon l'une quelconque des revendications 1 à 10,
**caractérisé en ce**
**que** le ou un circuit d'équilibrage (40) est monté dans un circuit de rétroaction positive et/ou dans un circuit de contre-réaction de l'amplificateur (10).

12. Détecteur de proximité inductif selon l'une quelconque des revendications 1 à 11,
**caractérisé en ce**
**que** le circuit d'équilibrage (40) est monté en parallèle ou en série par rapport à une résistance de rétroaction (R1).

13. Détecteur de proximité inductif selon l'une quelconque des revendications 1 à 12,
**caractérisé en ce**
**que** le dispositif de commutation électronique (20) est monté parallèlement à la résistance d'équilibrage (R2) et que la résistance d'équilibrage (R2) peut être désactivée par court-circuit par l'intermédiaire du dispositif de commutation électronique (20) ou
**que** le dispositif de commutation (20) est monté en série par rapport à la résistance d'équilibrage (R2) et que la résistance d'équilibrage (R2) peut être désactivée par ouverture du dispositif de commutation électronique (20).

14. Détecteur de proximité inductif selon l'une quelconque des revendications 1 à 13,
**caractérisé en ce**
**que** le dispositif de commutation électronique (20) est un commutateur analogique, en particulier à base CMOS.

15. Détecteur de proximité inductif selon l'une quelconque des revendications 1 à 14,
**caractérisé en ce**
**que** le dispositif de commande (30) est un microcontrôleur.

16. Détecteur de proximité inductif selon l'une quelconque des revendications 1 à 15,
**caractérisé en ce**
**que** le dispositif de commande (30) commande le dispositif de commutation électronique (20) de façon numérique.

17. Détecteur de proximité inductif selon l'une quelconque des revendications 1 à 16,
**caractérisé en ce**
**qu'**un dispositif de mesure de température destiné à mesurer la température au moins du circuit résonant est présent et que, sur la base d'une température mesurée par le dispositif de mesure de température, la série de commutations peut être modifiée pour compenser des dérives en température.

18. Détecteur de proximité inductif selon l'une quelconque des revendications 1 à 17,
**caractérisé en ce**

que le dispositif de commande (30) est conçu pour régler une distance de commutation par modification de la série de commutations.

19. Détecteur de proximité inductif selon l'une quelconque des revendications 1 à 18,
**caractérisé en ce**
que le dispositif de commande (30) pour fournir une hystérèse de commutation est conçu
pour augmenter, en particulier légèrement, la distance de commutation après commutation du détecteur de proximité en raison d'un rapprochement d'une cible du détecteur de proximité et
pour diminuer, en particulier légèrement, la distance de commutation après commutation du détecteur de proximité en raison d'un éloignement de la cible du détecteur de proximité.

20. Détecteur de proximité inductif selon la revendication 19,
**caractérisé en ce**
que le dispositif de commande (30) pour fournir une hystérèse de commutation est conçu pour augmenter la valeur moyenne temporelle de la résistance électrique du circuit d'équilibrage après commutation du détecteur de proximité en raison d'un rapprochement d'une cible du détecteur de proximité, et pour réduire la valeur moyenne temporelle de la résistance électrique du circuit d'équilibrage après commutation du détecteur de proximité en raison d'un éloignement de la cible du détecteur de proximité ou que le dispositif de commande (30) pour fournir une hystérèse de commutation est conçu pour réduire la valeur moyenne temporelle de la résistance électrique du circuit d'équilibrage après commutation du détecteur de proximité en raison d'un rapprochement d'une cible du détecteur de proximité et pour augmenter la valeur moyenne temporelle de la résistance électrique du circuit d'équilibrage après commutation du détecteur de proximité en raison d'un éloignement de la cible du détecteur de proximité.

Fig. 1

Fig. 2

Fig. 3

Fig. 4

Fig. 5

Fig. 6

Fig. 7

## Stand der Technik

Fig. 8

**IN DER BESCHREIBUNG AUFGEFÜHRTE DOKUMENTE**

**In der Beschreibung aufgeführte Patentdokumente**

- DE 102007014343 B4
- US 20100225332 A1
- DE 102009028619 A1
- DE 102010042512 A1
- DE 102010002201 A1
- EP 0461550 A2